(19) **Europäisches Patentamt / European Patent Office / Office européen des brevets**

(11) **EP 2 859 421 B1**

(12) **FASCICULE DE BREVET EUROPEEN**

(45) Date de publication et mention de la délivrance du brevet:
**11.05.2016 Bulletin 2016/19**

(21) Numéro de dépôt: **13733370.4**

(22) Date de dépôt: **07.06.2013**

(51) Int Cl.:
*G05B 23/02* *(2006.01)*    *G06Q 10/00* *(2012.01)*
*G06Q 50/30* *(2012.01)*

(86) Numéro de dépôt international:
**PCT/FR2013/051306**

(87) Numéro de publication internationale:
**WO 2013/182823 (12.12.2013 Gazette 2013/50)**

(54) **PRÉVISION D'OPÉRATIONS DE MAINTENANCE À APPLIQUER SUR UN MOTEUR**

VORHERSAGE VON WARTUNGSOPERATIONEN FÜR EINEN MOTOR

FORECASTING MAINTENANCE OPERATIONS TO BE APPLIED TO AN ENGINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.06.2012 FR 1255384**

(43) Date de publication de la demande:
**15.04.2015 Bulletin 2015/16**

(73) Titulaire: **SNECMA**
**75015 Paris (FR)**

(72) Inventeurs:
• **ANFRIANI, Alexandre**
  **F-77550 Moissy-Cramayel Cedex (FR)**
• **BRUN, Cyril**
  **F-77550 Moissy-Cramayel Cedex (FR)**

• **SEMPERE, Julian**
  **F-77550 Moissy-Cramayel Cedex (FR)**

(74) Mandataire: **Brevalex**
**95, rue d'Amsterdam**
**75378 Paris Cedex 8 (FR)**

(56) Documents cités:
**US-A1- 2006 126 608    US-A1- 2008 234 979**

• **MURAD S SAMHOURI: "An intelligent opportunistic maintenance (OM) system: A genetic algorithm approach", SCIENCE AND TECHNOLOGY FOR HUMANITY (TIC-STH), 2009 IEEE TORONTO INTERNATIONAL CONFERENCE, IEEE, PISCATAWAY, NJ, USA, 26 septembre 2009 (2009-09-26), pages 60-65, XP031655835, ISBN: 978-1-4244-3877-8**

## Description

### DOMAINE DE L'INVENTION

La présente invention se rapporte au domaine de la maintenance d'un moteur. En particulier, l'invention concerne un procédé et un système pour optimiser la prévision des opérations de maintenance à appliquer sur un moteur qui peut par exemple être celui d'un aéronef.

De manière générale, la maintenance consiste à intervenir directement sur le moteur en fonction de la cause de défaillance, sans se préoccuper des autres paramètres. Par exemple, si une fuite d'huile a été détectée, on agit sur le circuit d'huile et ainsi de suite.

Cependant, une opération de maintenance sur un moteur peut nécessiter une longue période d'immobilisation et des coûts importants de pièces et de main d'oeuvre.

Alors, afin de planifier les opérations de maintenance, on exploite le retour d'expérience accumulée par les réparateurs dans les ateliers sur les causes de défaillances pour tracer des courbes de défaillances statistiques basées sur des lois de Weibull. L'outil utilisé actuellement consiste à utiliser le retour d'expérience et les lois de Weibull pour attribuer une durée de vie à chaque composant du moteur afin de faire une analyse du risque. Cette analyse permet d'évaluer le risque pour un composant d'atteindre un état de dégradation avancée. Ainsi, on définit pour chaque composant une période régulière d'inspection pour que ce risque soit inférieur à un seuil de sécurité réglementaire.

Cependant, lorsqu'on déclenche une inspection sur un composant particulier, il est peu probable que l'opérateur n'aille pas inspecter le composant qui est juste à côté et surtout si ce dernier est facilement accessible. Ainsi, dans la réalité, on effectue beaucoup plus d'inspections que ce qui est exigé par la réglementation. Ceci engendre une augmentation des coûts de maintenance et des périodes d'immobilisation. De plus, ceci peut induire un manque de précision dans la prévision d'opérations de maintenance et la gestion des stocks.

On connaît dans l'art antérieur le document US 2008/0234979, qui décrit un procédé d'optimisation de maintenance sur un moteur, comprenant une sélection de différents paramètres tels des données de planification relatives au moteur, des règles de maintenance, et une décision de maintenance.

On connaît également l'article de Murad S. Samhouri, « An Intelligent Opportunistic Maintenance (OM) System : A Genetic Algorithm Approach », TIC-STH 2009, IEEE, pages 60-65. Cet article décrit une approche basée sur les algorithmes de la génétique, pour décider de mettre en oeuvre ou non une maintenance dite opportuniste, c'est-à-dire la mise en oeuvre d'opérations de maintenance programmées à l'occasion d'une panne inattendue.

Enfin, le document US 2006/0126608 décrit la surveillance d'un système aéronautique comportant l'acquisition de données relatives aux composants du système, et l'extraction de paramètres relatifs à ces composants à l'aide de connaissances antérieures du système.

L'objet de la présente invention est par conséquent de planifier avec précision et de manière optimale les opérations de maintenance sur un moteur tout en respectant toutes les exigences et contraintes de sécurité.

### OBJET ET RÉSUMÉ DE L'INVENTION

La présente invention concerne un procédé de prévision d'opérations de maintenance à appliquer sur un moteur ou une partie du moteur comportant un ensemble de composants, le procédé comportant les étapes suivantes :

- construire un modèle de durée de vie pour chaque composant dudit ensemble de composants,
- analyser le modèle de durée de vie associé à chaque composant pour construire un ensemble de modèles de défaillances correspondant audit ensemble de composants, chaque composant étant associé à un modèle de défaillance définissant un intervalle d'inter-inspection traduisant un taux de risque de dégradation avancée inférieur à un seuil de sécurité prédéterminé,
- définir une stratégie de maintenance comprenant des inspections opportunistes sur ledit ensemble de composants,
- simuler de manière itérative des actions de maintenance sur ledit ensemble de composants en utilisant ledit ensemble de modèles de défaillances et ladite stratégie de maintenance pour construire un modèle global d'opérations de maintenance relaxée qui prend en compte les inspections opportunistes tout en respectant le seuil de sécurité prédéterminé de chaque composant.

Le modèle global d'opérations de maintenance relaxée permet de maîtriser l'impact des inspections opportunistes sur les provisions et de calibrer les plans d'inspections pour une flotte de moteurs. Ceci permet en particulier de minimiser le nombre de déposes, l'incertitude des prévisions ainsi que les coûts d'intervention lors des déposes tout en respectant les exigences de sécurité.

Avantageusement, chaque itération de ladite simulation comporte les étapes suivantes :

- modifier au moins un intervalle d'inter-inspection correspondant à au moins un composant en tenant compte des inspections opportunistes pour construire un modèle courant de maintenance,
- comparer le taux de risque associé à chaque composant selon ledit modèle courant de maintenance avec le seuil de sécurité prédéterminé dudit composant selon les modèles de défaillances, et

EP 2 859 421 B1

- continuer la simulation jusqu'à ce que le modèle courant de maintenance converge vers un dernier modèle courant de maintenance qui maximise les intervalles d'inter-inspection des composants tout en respectant le seuil de sécurité prédéterminé de chaque composant, ledit dernier modèle courant de maintenance étant ledit modèle global d'opérations de maintenance relaxée.

Ceci permet de simuler de manière stochastique l'ensemble des règles de maintenance et des dégradations tout en vérifiant de manière simple si on a dérivé par rapport à la maintenance initiale selon les modèles de défaillances. Ainsi, on peut prendre en compte les inspections opportunistes (qui ne seraient pas prises en compte lorsqu'on fait une analyse de risque composant par composant) tout en conservant toutes les règles de sécurité.

Avantageusement, le procédé comporte en outre la définition d'un modèle de comportement du moteur comprenant des données de comportement parmi l'ensemble de données suivantes : temps d'exploitation moyen du moteur, durée moyenne des missions, nombre de missions par jour, âge du moteur, et maintenances déjà réalisées sur le moteur.

Ces informations sont utiles pour initialiser la simulation du vieillissement des composants et d'affiner les prévisions calendaires.

Avantageusement, le procédé comporte en outre la détermination de prévisions calendaires des actions de maintenance à appliquer sur ledit moteur en tenant compte dudit modèle de comportement du moteur.

Ceci permet d'optimiser la gestion des stocks en pièces de rechange.

Avantageusement, la construction d'un modèle de durée de vie pour un composant donné comporte les étapes suivantes :

- déterminer une première loi d'un premier temps de passage $t_{D/S}$ d'un état sain vers un état de dégradation intermédiaire dudit composant,
- déterminer une deuxième loi d'un deuxième temps de passage $t_{EO/S}$ d'un état sain vers un état de dégradation avancée dudit composant, et
- utiliser lesdites première et deuxième lois pour estimer une troisième loi d'un troisième temps de passage $t_{EO/D}$ de l'état de dégradation intermédiaire vers l'état de dégradation avancée dudit composant, ladite troisième loi étant estimée selon une loi d'association de dépendance forte entre lesdites première et deuxième lois si ces dernières sont dépendantes, et ladite troisième loi étant estimée selon une loi d'association de dépendance à minima d'information si lesdites première et deuxième lois sont indépendantes, sous contrainte que le premier temps de passage soit plus petit que le deuxième temps de passage.

Ceci permet d'estimer une loi robuste du temps de passage de l'état de dégradation intermédiaire vers l'état de dégradation avancée en tenant compte de la dépendance ou de l'indépendance des phénomènes de dégradations entre les différents états.

Avantageusement, la construction d'un modèle de durée de vie comporte les étapes suivantes :

- simuler un échantillon de nombres $\alpha_i$ uniformément répartis sur un intervalle [0;1],
- calculer des premier quantiles $q_{D/S}(\alpha_i)$ et des deuxième quantiles $q_{EO/S}(\alpha_i)$ de niveau $\alpha_i$ desdites première et deuxième lois respectivement, et
- estimer ladite troisième loi en fonction desdits premier et deuxième quantiles.

Ceci permet de simuler un échantillon de la première loi et un échantillon de la deuxième loi et de faire une association cohérente entre les premier et deuxième temps de passage.

Selon une première approche, si lesdites première et deuxième lois sont dépendantes, la troisième loi est estimée selon des quantiles $q_{EO/D}(\alpha_i)$ égaux à la différence entre les premiers $q_{D/S}(\alpha_i)$ et deuxièmes $q_{EO/S}(\alpha_i)$ quantiles desdites première et seconde lois.

Ceci est une représentation cohérente et robuste du cas où le phénomène qui provoque le passage de l'état sain à l'état de dégradation intermédiaire est le même que celui qui provoque le passage de l'état de dégradation intermédiaire à l'état de dégradation avancée.

Selon une seconde approche, si lesdites première et deuxième lois sont indépendantes, l'estimation de la troisième loi comporte les étapes suivantes :

- associer des durées de passage des premiers $q_{D/S}(\alpha_i)$ et deuxièmes $q_{EO/S}(\alpha_i)$ quantiles, en garantissant une indépendance entre elles sous contrainte que le premier temps de passage $t_{D/S}$ soit plus petit que le deuxième temps de passage $t_{EO/S}$, et
- estimer la troisième loi selon un échantillon de durée déterminé par soustraction desdites durées de passage des premiers $q_{D/S}(\alpha_i)$ et deuxièmes $q_{EO/S}(\alpha_i)$ quantiles associées entre elles.

Ceci permet de maximiser la notion d'indépendance entre le phénomène qui provoque le passage de l'état sain à l'état de dégradation intermédiaire et celui qui provoque le passage de l'état de dégradation intermédiaire à l'état de dégradation avancée.

Avantageusement, le procédé selon l'une quelconque des caractéristiques ci-dessus est utilisé pour une flotte de moteurs d'aéronef.

L'invention vise également un système de prévision d'opérations de maintenance à appliquer sur un moteur ou une partie du moteur comportant un ensemble de composants, caractérisé en ce qu'il comporte :

- des moyens de traitement pour construire un modèle de durée de vie pour chaque composant dudit ensemble de composants,

- des moyens de traitement pour analyser le modèle de durée de vie associé à chaque composant afin de construire un ensemble de modèles de défaillances correspondant audit ensemble de composants, chaque composant étant associé à un modèle de défaillance définissant un intervalle d'inter-inspection traduisant un taux de risque de dégradation avancée inférieur à un seuil de sécurité prédéterminé,

- des moyens de traitement pour définir une stratégie de maintenance comprenant des inspections opportunistes sur ledit ensemble de composants, et

- des moyens de traitement pour simuler de manière itérative des actions de maintenance sur ledit ensemble de composants en utilisant ledit ensemble de modèles de défaillances et ladite stratégie de maintenance afin de construire un modèle global d'opérations de maintenance relaxée qui prend en compte les inspections opportunistes tout en respectant le seuil de sécurité prédéterminé de chaque composant.

## BRÈVE DESCRIPTION DES DESSINS

D'autres particularités et avantages du dispositif et du procédé selon l'invention ressortiront mieux à la lecture de la description faite ci-après, à titre indicatif mais non limitatif, en référence aux dessins annexés sur lesquels :

- la Figure 1 illustre de manière schématique un système de prévision d'opérations de maintenance à appliquer sur un moteur ou une partie d'un moteur selon l'invention ;

- la Figure 2 est un logigramme par bloc illustrant un mode de réalisation préféré du procédé de prévision d'opérations de maintenance sur un moteur, selon l'invention ;

- la Figure 3A est un graphe de type Markov modélisant un scénario de défaillance d'un composant entre différents états ;

- la Figure 3B illustre la détermination des première et deuxième lois de passage, selon l'invention ;

- la Figure 3C est un organigramme illustrant la détermination d'une troisième loi de passage à partir des première et deuxième lois, selon l'invention ;

- la Figure 3D est un organigramme illustrant un exemple d'association des durées de vies à dégradation intermédiaire et à dégradation avancée dans le cas où les première et deuxième lois sont indépendantes, selon l'invention ;

- les Figures 4A et 4B explicitent la construction d'un modèle de défaillance correspondant à un composant, selon l'invention ;

- la Figure 5 illustre la structure d'un processus d'inspections opportunistes, selon l'invention ;

- la Figure 6 illustre les grandes étapes de simulation des actions de maintenance sur un ensemble de composants, selon l'invention ;

- la Figure 7 est un exemple d'un système comportant trois composants permettant d'expliciter avec plus de détail le procédé de prévision d'opérations de maintenance, selon l'invention ;

- les Figures 8A-8C représentent les graphiques des lois de Weibull pour les trois composants de la Figure 7 ;

- la Figure 9 illustre la structure d'un processus d'inspections opportunistes pour les trois composants de la Figure 7 ;

- les Figures 10A-10C représentent les graphiques des modèles de défaillances pour les trois composants de la Figure 7 ;

- la Figure 11 illustre un algorithme de simulation des actions de maintenance sur les trois composants de la Figure 7 ;

- les Figures 12A-12C représentent les graphiques des modèles de défaillances tenant compte des inspections opportunistes pour les trois composants de la Figure 7 ; et

- la Figure 13 est un schéma en bloc illustrant la détermination des prévisions calendaires selon l'invention.

## DESCRIPTION DÉTAILLÉE DE MODES DE RÉALISATION

Le principe de l'invention consiste à exploiter au mieux l'interdépendance entre les inspections pour optimiser le plan de maintenance d'une flotte de moteurs. Ainsi, en tenant compte des inspections opportunistes, il est possible d'augmenter les périodes ou intervalles d'inter-inspection tout en restant cohérent vis-à-vis des exigences de sécurité.

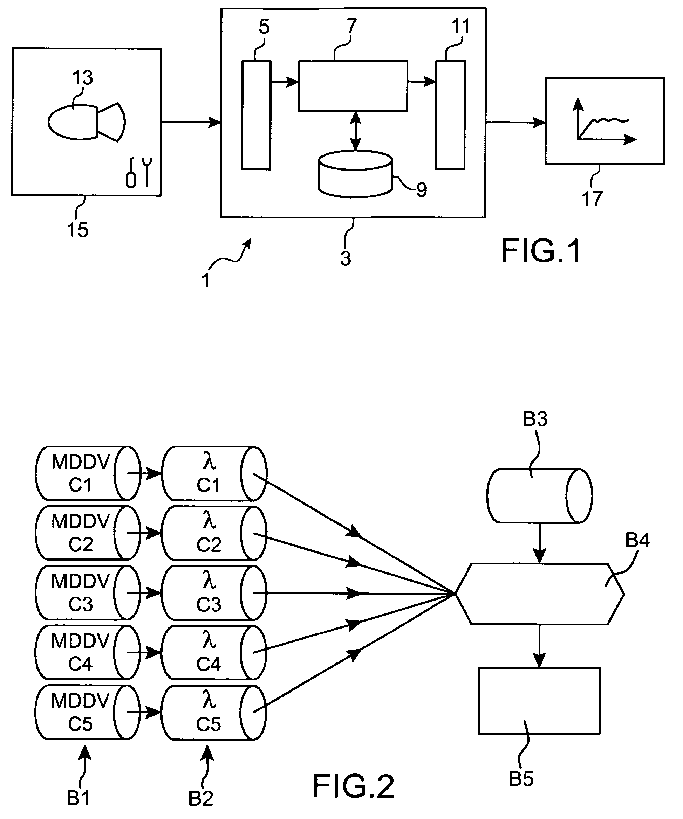

La Figure 1 illustre de manière schématique un système de prévision d'opérations de maintenance à appliquer sur un moteur ou une partie d'un moteur selon l'invention.

Le système de prévision 1 comporte un système informatique 3 comprenant de manière habituelle des moyens d'entrée 5, des moyens de traitement 7, des moyens de stockage 9, et des moyens de sortie 11. On notera que les moyens de stockage 9 peuvent comporter un programme d'ordinateur comprenant des instructions de code adaptées à la mise en oeuvre du procédé de prévision selon l'invention. Ce programme d'ordinateur peut être exécuté par les moyens de traitement 7 en relation avec les moyens de stockage 9 et les moyens d'entrée 5 et de sortie 11.

On notera que le système et le procédé s'appliquent à tout type de moteur destiné à effectuer un travail à partir d'une énergie thermique, électrique, chimique, ou autre. Dans le cas décrit ci-après, on s'intéressera plus particulièrement à la prévision d'opérations de maintenance à appliquer sur un moteur d'aéronef comportant une pluralité de composants.

Lors des passages des moteurs 13 d'aéronef en ateliers 15, les réparateurs accumulent une expérience sur les défaillances et les niveaux d'intervention des différents composants. En particulier, les données de retour d'expérience sur toute une flotte de moteurs 13 peuvent comporter l'état de dégradation (intermédiaire ou avancée) de chaque composant, les causes de ces dégradations, les âges des composants (sains et défectueux) inspectés, l'environnement d'opération de chaque moteur, la condition opérationnelle de chaque moteur, etc.

Ce retour d'expérience est exploité par le système de prévision 1 pour construire des modèles de durée de vie MDDV. En effet, les moyens de traitement 7 sont configurés pour recevoir via les moyens d'entrée 5 les différentes données issues du retour d'expérience depuis les différents ateliers 15 et les exploiter afin de construire un modèle de durée de vie pour chaque composant de l'ensemble de composants du moteur 13.

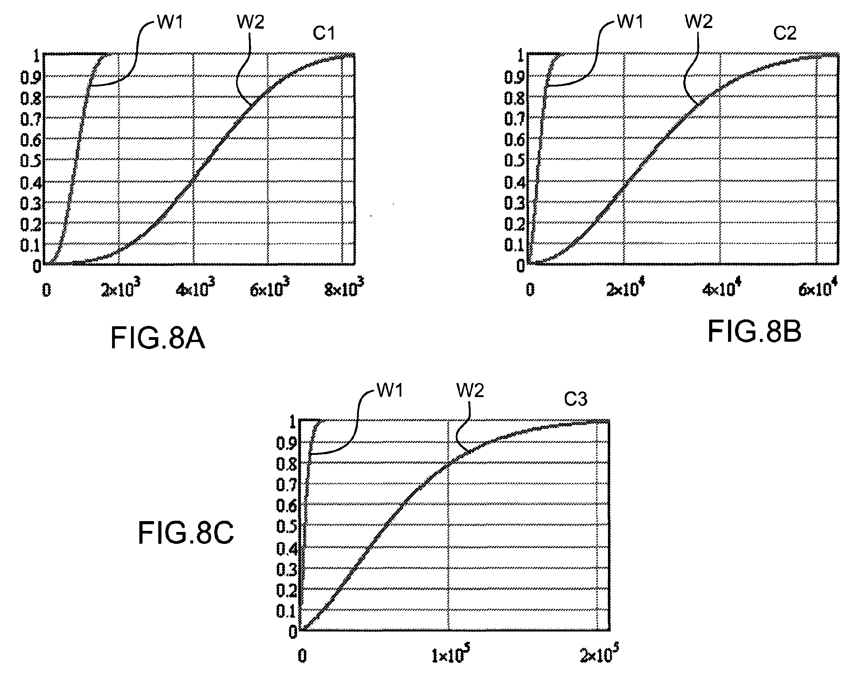

Chaque modèle de durée de vie peut être défini par des fonctions de répartition de temps de passages relatifs à des états de dégradation visités par un composant durant sa vie opérationnelle (voir par exemple Figures 8A-8C). Chaque fonction de répartition peut être modélisée par une courbe de probabilité cumulée de durée de vie basée par exemple sur une loi ou distribution de Weibull. La fonction de répartition $F_{\beta,\eta}$ d'une distribution de Weibull peut être exprimée selon la formule simplifiée suivante :

$$F_{\beta,\eta} = 1 - e^{-\left(\frac{t}{\eta}\right)^{\beta}}$$

Cette distribution de Weibull est extrêmement flexible grâce à la prise en compte d'un paramètre de forme $\beta$ et d'un paramètre d'échelle $\eta$.

Les moyens de traitement 7 sont en outre configurés pour analyser le modèle de durée de vie associé à chaque composant afin de construire un ensemble de modèles de défaillances correspondant à l'ensemble de composants, chaque composant étant associé à un modèle de défaillance définissant un intervalle d'inter-inspection. Le temps ou l'intervalle d'inter-inspection d'un composant donné traduit un niveau ou taux de risque de dégradation avancée inférieur à un seuil de sécurité prédéterminé.

On notera que les différents modèles de durée de vie ainsi que l'ensemble de modèles de défaillances peuvent être enregistrés dans les moyens de stockage 9 et éventuellement affichés sur des moyens de visualisation 17 connectés aux moyens de sortie 11.

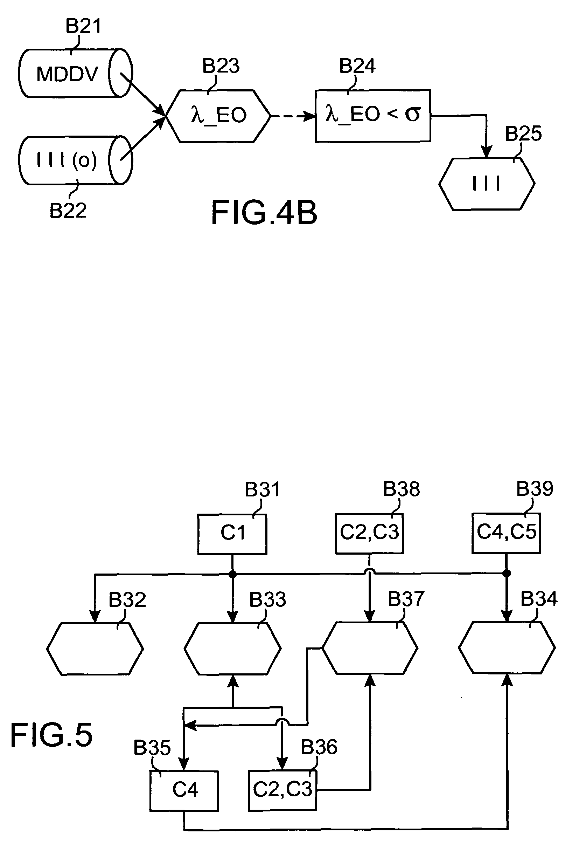

En outre, les moyens de stockage 9 sont configurés pour contenir des plans de maintenance comportant des inspections opportunistes sur les différents composants. Plus particulièrement, les moyens de traitement 7 en relation avec les moyens de stockage 9 sont configurés pour définir un plan ou une stratégie de maintenance sur l'ensemble de composants, comprenant des inspections ou actions de maintenance opportunistes. Ainsi, une inspection programmée pour un ou plusieurs composants peut provoquer un certain nombre d'inspections opportunistes sur d'autres composants (voir Figure 5).

Conformément à l'invention, les moyens de traitement 7 sont configurés pour simuler de manière itérative des actions de maintenance sur l'ensemble de composants en utilisant l'ensemble de modèles de défaillances et la stratégie de maintenance pour construire un modèle global d'opérations de maintenance relaxée qui prend en compte les inspections opportunistes tout en respectant le seuil de sécurité prédéterminé de chaque composant. Les états visités par l'ensemble de composants peuvent être simulés en tenant compte de la stratégie de maintenance, selon une méthode de Monte Carlo de type réseaux de Petri. Ainsi, en partant d'un état initial, la simulation peut se définir de manière récursive en réévaluant à chaque itération les taux de risque de dégradations avancées générant de proche en proche des intervalles d'inter-inspection de plus en plus relaxés.

Les Figures 2-6 sont des organigrammes illustrant le procédé de prévision d'opérations de maintenance sur un moteur selon l'invention.

Plus particulièrement, la Figure 2 est un logigramme par bloc illustrant un mode de réalisation préféré du procédé de prévision d'opérations de maintenance sur un moteur, selon l'invention.

Aux blocs B1, on construit les modèles de durée de vie MDDV pour l'ensemble de composants.

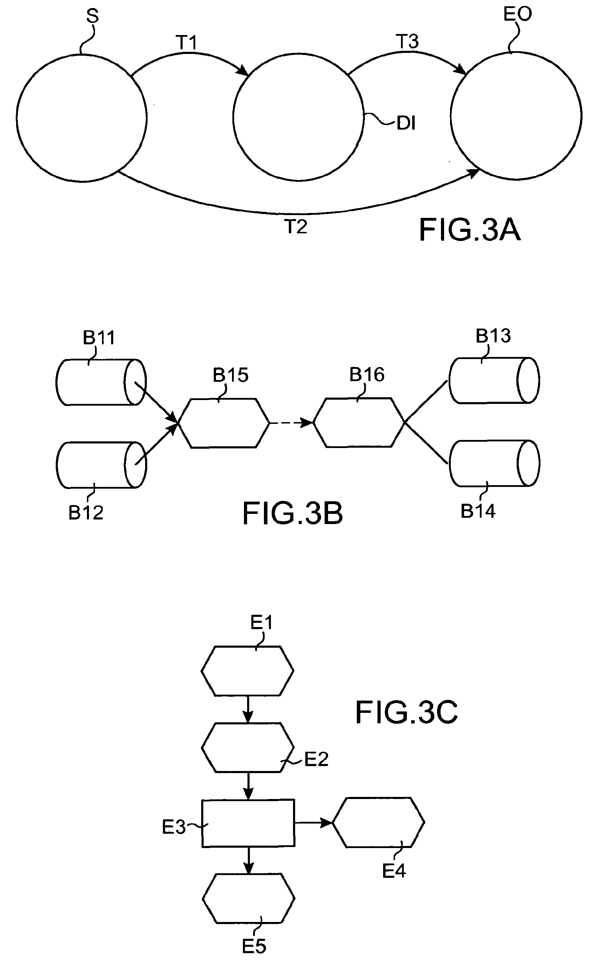

Les Figures 3A-3C explicitent avec plus de détails la construction d'un modèle de durée de vie pour un composant.

La Figure 3A est un graphe de type Markov modélisant un scénario de défaillance d'un composant entre différents états.

Le processus de défaillance d'un composant est défini dans un espace d'états discret constitué de trois états : un état sain S, un état de dégradation intermédiaire DI, et un état de dégradation avancée pouvant conduire à un événement opérationnel EO. Le graphe montre que le composant visite durant sa vie opérationnelle deux états successifs de dégradation. Le premier de ces états de dégradation (dégradation intermédiaire DI) est un état transitoire de dégradation détectable en inspection et le dernier état (dégradation avancée) conduisant à un événement opérationnel EO. Le graphe est modélisé de sorte que l'état de dégradation avancée EO soit accessible à partir de l'état sain S ainsi qu'à partir de l'état de dégradation intermédiaire EI qui lui n'est accessible qu'à partir de l'état sain S.

La construction d'un modèle de durée de vie d'un composant comporte alors l'estimation des lois de transitions entre les différents états. Une première loi de transition (représentée par la flèche T1) est associée à un temps de passage $t_{D/S}$ d'un état sain S vers un état de dégradation intermédiaire DI (appelé aussi la durée de vie à dégradation intermédiaire DVDI); une deuxième loi de transition (flèche T2) est associée à un temps de passage $t_{EO/S}$ d'un état sain S vers un état de dégradation avancée EO (appelé aussi la durée de vie à dégradation avancée DVEO) ; et une troisième loi de transition (flèche T3) est associée à un temps de passage $t_{EO/D}$ de l'état de dégradation intermédiaire DI vers l'état de dégradation avancée EO.

La Figure 3B illustre la détermination des première et deuxième lois de passage.

On notera qu'en phase d'exploitation des moteurs, on a connaissance des résultats d'inspections des composants comme par exemple le temps de fonctionnement et l'état de dégradation de chaque composant inspecté. D'autre part, on a connaissance de quelques très rares événements opérationnels en vol imputables à l'endommagement d'un composant via une dégradation trop avancée. Ces données d'observation ou de retour d'expérience permettent de déterminer les première et deuxième lois de passage.

Ainsi, des lois de passage de la forme Weibull ou Log-Normale peuvent être déterminées à partir des données d'observation stockées dans les moyens de stockage 9.

Plus particulièrement, le bloc B11 représente des premières données d'observation comprenant les âges des composants inspectés et sains. Le bloc B12 représente des deuxièmes données d'observation comprenant les âges des composants inspectés et dégradés. Le bloc B13 représente des troisièmes données d'observation comprenant les âges des composants en service. Le bloc B14 représente des quatrièmes données d'observation comprenant les âges des composants lors d'un événement opérationnel.

Au bloc B15, les moyens de traitement 7 sont configurés pour déterminer pour un composant donné, la première loi de temps de passage $t_{D/S}$ d'un état sain S vers un état de dégradation intermédiaire DI. Les paramètres de cette première loi de durée de vie à dégradation intermédiaire DVDI peuvent être estimés selon une méthode statistique de type maximum de vraisemblance au vu des données d'observations des blocs B11 et B12.

De même, au bloc B16, les moyens de traitement 7 sont configurés pour déterminer pour un composant donné, la deuxième loi de temps de passage $t_{EO/S}$ d'un état sain S vers un état de dégradation avancée EO. Les paramètres de cette deuxième loi de durée de vie à dégradation avancée DVEO peuvent a priori être également estimés selon la méthode de maximum de vraisemblance au vu des données d'observations des blocs B13 et B14. Cependant, la rareté des données d'observations du bloc B14 rend l'estimation directe de la deuxième loi très imprécise. Ainsi, la flèche en pointillé entre les blocs B15 et B16 montre qu'il est souvent nécessaire de s'appuyer sur l'estimation de la première loi pour estimer la deuxième loi. On récupère surtout une information concernant la dispersion en conjecturant que la dispersion de la deuxième loi de DVEO est la même que celle observée sur la première loi de DVDI.

Toutefois, on n'observe presque jamais le passage de l'état de dégradation intermédiaire DI vers l'état de dégradation avancée EO. En effet, lorsqu'on repère l'état de dégradation intermédiaire DI d'un composant, on remplace le composant ou la(les) pièce(s) dégradée(s) du composant avant de reprendre l'exploitation du moteur.

La troisième loi de passage n'étant pas directement accessible via le retour d'expérience, elle peut être avantageusement déduite des première et deuxième lois via un processus de séparation de lois illustré par l'organigramme de la Figure 3C.

Selon une première approche (voir étape E4), la troisième loi est estimée selon une loi d'association de dépendance forte entre les première et deuxième lois si ces dernières sont dépendantes.

Selon une seconde approche (voir étape E5), la troisième loi est estimée selon une loi d'association de dépendance à minima d'information si les première et deuxième lois sont indépendantes, sous contrainte que le premier temps de passage DVDI soit plus petit que le deuxième temps de passage DVEO.

Les étapes E1 et E2 sont communes aux deux approches.

A l'étape E1, on simule un échantillon de nombres $\alpha_i$ uniformément répartis sur un intervalle [0; 1]. Chaque tirage peut être réalisé par un générateur de nombres aléatoires et la taille d'échantillon peut par exemple être de l'ordre de $10^5$ tirages.

A l'étape E2, on calcule un premier quantile $q_{D/S}(\alpha_i)$ de niveau $\alpha_i$ relatif à la première loi de dégradation intermédiaire et un deuxième quantile $q_{EO/S}(\alpha_i)$ de niveau relatif à la deuxième loi de dégradation avancée. Le premier quantile $q_{D/S}(\alpha_i)$ est relatif à la durée de vie à dégradation intermédiaire DVDI et le deuxième quantile $q_{EO/S}(\alpha_i)$ est relatif à la durée de vie à dégradation avancée DVEO. On notera qu'un quantile $q(\alpha)$ d'une variable aléatoire X vérifie la probabilité $P(X < q(\alpha) = \alpha$. Autrement dit, le quantile est un point de la loi d'origine qui lorsqu'on le compose par la fonction de répartition (loi de Weibull) donne un point entre 0 et 1 qui est exactement égal à $\alpha$. Ainsi, pour simuler la troisième loi, il suffit de faire le chemin inverse.

L'étape E3 est pour sélectionner soit une approche de dépendance, soit une approche d'indépendance entre les première et deuxième lois. C'est une hypothèse d'entrée dans la modélisation qui dépend de la nature des phénomènes de dégradation.

Si le phénomène qui provoque le passage de l'état sain à l'état de dégradation intermédiaire est le même que celui qui provoque le passage de l'état de dégradation intermédiaire à l'état de dégradation avancée, alors on peut considérer que les première et deuxième lois sont dépendantes. Par exemple, on peut avoir une même sollicitation qui provoque l'usure d'un premier revêtement selon une première échelle temporelle impliquant une dégradation intermédiaire et ensuite l'usure d'un second revêtement selon une seconde échelle temporelle impliquant une dégradation avancée. Dans ce cas, les première et deuxième lois liées au phénomène d'usure peuvent être considérées comme dépendantes.

En revanche, si le phénomène qui provoque le passage de l'état sain à l'état de dégradation intermédiaire n'est pas le même que celui qui provoque le passage de l'état de dégradation intermédiaire à l'état de dégradation avancée, alors on peut considérer que les première et deuxième lois sont indépendantes. Par exemple, l'amorçage de fissures impliquant une dégradation intermédiaire n'obéit pas à la même cinétique que la propagation de fissures qui peut déclencher un événement opérationnel. Dans ce cas, les première et deuxième lois liées respectivement à l'amorçage et à la propagation de fissures peuvent être considérées comme indépendantes. Un autre exemple d'indépendance concerne l'ingestion par le moteur d'un corps étranger. L'impact qui peut engendrer une dégradation intermédiaire diffère complètement de la nature des phénomènes ultérieurs qui peuvent provoquer des dégâts à évolution lente pouvant déclencher un événement opérationnel.

On notera que sous une hypothèse de dépendance, un petit temps de passage de l'état sain S vers l'état de dégradation intermédiaire DI peut par exemple, être systématiquement associé à un petit temps de passage de l'état de dégradation intermédiaire DI vers l'état de dégradation avancée EO. En revanche, sous l'hypothèse d'indépendance, la connaissance du temps de passage de l'état sain S vers l'état de dégradation intermédiaire DI n'apporte aucune information sur le temps de passage de l'état de dégradation intermédiaire DI vers l'état de dégradation avancée EO.

Dans le cas où les première et deuxième lois sont dépendantes, on va à l'étape E4, sinon, on va à l'étape E5.

A l'étape E4, les première et deuxième lois sont considérées comme dépendantes. Dans ce cas, la troisième loi est estimée selon des quantiles $q_{EO/D}(\alpha_i)$ égaux à la différence entre les premiers $q_{D/S}(\alpha_i)$ et deuxièmes $q_{EO/S}(\alpha_i)$ quantiles des première et seconde lois. On notera que pour simuler la troisième loi, il suffit d'associer les couples des premiers $q_{D/S}(\alpha_i)$ et deuxièmes $q_{EO/S}(\alpha_i)$ quantiles. Autrement dit, il suffit de construire un échantillon de couples (DVDI$_i$; DVEO$_i$) associant chaque durée de vie à dégradation intermédiaire DVDI$_i$ à une durée de vie à dégradation avancée DVEO$_i$ correspondante.

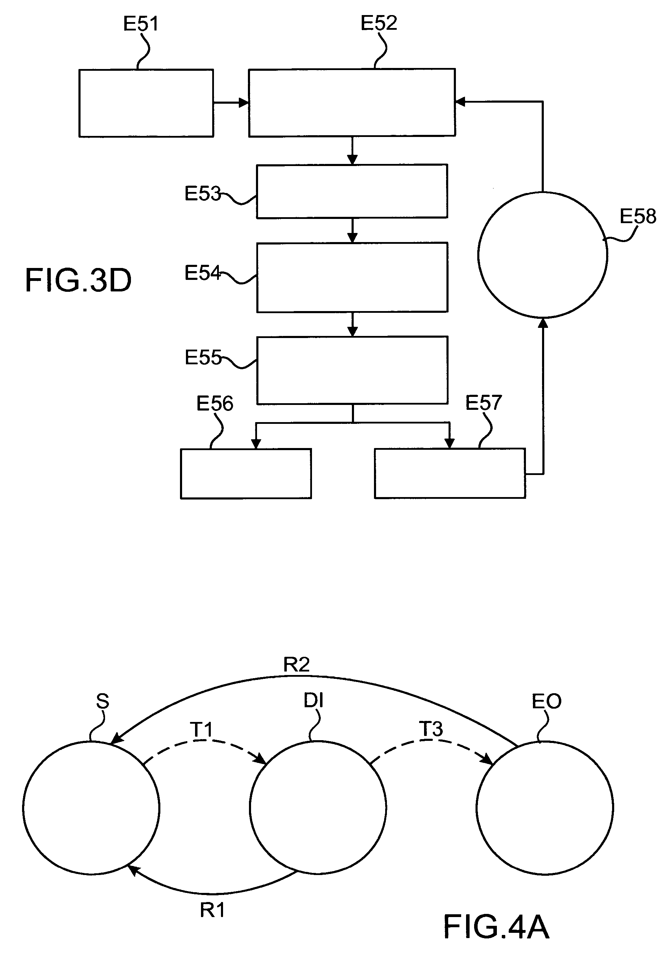

A l'étape E5, les première et deuxième lois étant considérées comme indépendantes, on associe des durées de passage des premiers $q_{D/S}(\alpha_i)$ et deuxièmes $q_{EO/S}(\alpha_i)$ quantiles (c'est-à-dire, former des couples (DVDI$_i$; DVEO$_k$)), en garantissant une indépendance entre elles sous contrainte que le premier temps de passage $t_{D/S}$ soit plus petit que le deuxième temps de passage $t_{EO/D}$ (c'est-à-dire, DVDI$_i$<DVEO$_k$). Un exemple d'une telle association est illustré sur la Figure 3D.

On notera que cette association entre les premiers $q_{D/S}(\alpha_i)$ et deuxièmes $q_{EO/S}(\alpha_i)$ quantiles suffit pour simuler la troisième loi.

Néanmoins, on peut estimer à l'étape E6 la troisième loi selon un échantillon de durées de vies, déterminé par soustraction des durées de passage des premiers $q_{D/S}(\alpha_i)$ et deuxièmes $q_{EO/S}(\alpha_i)$ quantiles correspondantes.

La Figure 3D est un organigramme illustrant un exemple d'association des durées de vies à dégradation intermédiaire DVDI et à dégradation avancée DVEO dans le cas où les première et deuxième lois sont indépendantes.

Ici, il s'agit de simuler des couples (DVDI ; DVEO) de durées de vies à dégradation intermédiaire DVDI et à dégradation avancée DVEO sous hypothèse de dépendance minimale, c'est-à-dire, en injectant le minimum d'information sur le lien entre ces deux variables autres que l'ordre stochastique. En d'autres termes, il s'agit de garantir le meilleur niveau d'indépendance sous contrainte de l'inégalité suivante : DVDI<DVEO.

A l'étape E51, les moyens de traitement 7 simulent un échantillon de la variable DVDI et un échantillon de la variable DVEO de même taille N et de telle sorte que pour chaque valeur DVDI$_i$, on puisse trouver une valeur DVEO$_i$ respectant l'ordre stochastique DVDI$_i$<DVEO$_i$. Ainsi, on a une liste S=(DVDI$_i$; DVEO$_i$) de couples, telle que toutes les associations (DVDI$_i$; DVEO$_i$) sont compatibles, c'est-à-dire, respectent l'ordre stochastique. On notera que l'étape E51 est la même que les étapes E1 et E2 de la Figure 3C. Autrement dit, à l'étape E51, on récupère un échantillon de couples simulé par l'organigramme de la Figure 3C.

A l'étape E52, les moyens de traitement 7 séparent les couples (DVDI$_i$; DVEO$_i$) définis à l'étape précédente en deux vecteurs compatibles de même taille N : un premier vecteur X pour les durées de vie à dégradation intermédiaire DVDI simulée et un second vecteur Y pour les durées de vie à dégradation avancée DVEO simulée. Autrement dit, le premier vecteur correspond aux durées de passage des premiers quantiles $X = q_{D/S}(\alpha_i)$ et le second vecteur correspond aux durées de passage des deuxièmes *quantiles* $Y = q_{EO/S}(\alpha_i)$.

Les étapes E53-E55 consistent à générer des nouveaux couples en respectant l'ordre stochastique.

Plus particulièrement, les moyens de traitement 7 sélectionnent à l'étape E53, la plus grande valeur de durée de vie à dégradation intermédiaire Max(DVDI$_i$) dans le vecteur X. On note x=Max(DVDI$_i$) cette plus grande valeur de durée de vie à dégradation intermédiaire DVDI.

A l'étape E54, les moyens de traitement 7 sélectionnent un sous vecteur Y$_{sup(x)}$ de durée de vie à dégradation avancée DVEO dont chaque élément présente une durée de vie supérieure à x. Ainsi, tous les éléments du sous vecteur Y$_{sup(x)}$ sont des candidats potentiels pour être associé à x car ils respectent la contrainte de l'ordre stochastique.

Ainsi, à l'étape E55, les moyens de traitement 7 sélectionnent selon un choix aléatoire uniforme un élément y de $Y_{sup(x)}$.

A l'étape E56, les moyens de traitement 7 associent l'élément x du vecteur X à l'élément y du sous vecteur $Y_{sup(x)}$ pour former le couple (x ; y).

A l'étape E57, les moyens de traitement 7 stockent ce couple dans les moyens de stockage 9.

A l'étape E58, les moyens de traitement 7 suppriment les éléments x et y appartenant aux vecteurs X et Y respectivement.

A l'étape E59, les moyens de traitement 7 rebouclent sur l'étape E52 pour recommencer les étapes E52-E58 jusqu'à N itérations. Ainsi, de proche en proche, on finit par associer tous les éléments des vecteurs X et Y compatibles avec l'ordre stochastique en injectant le minimum d'information. Cette manière de créer des perturbations permet d'augmenter l'entropie et donc de garantir un meilleur niveau d'indépendance entre les variables DVI et DVEO.

Revenons à la Figure 2, après avoir construit aux blocs B1, les modèles de durées de vie pour l'ensemble de composants, les moyens de traitement 7 construisent aux blocs B2 l'ensemble de modèles de défaillances correspondant à l'ensemble de composants.

Les Figures 4A et 4B explicitent avec plus de détails la construction d'un modèle de défaillance correspondant à un composant.

La Figure 4A est un graphe de type Markov modélisant la stratégie de maintenance pour un composant.

Le composant est inspecté à intervalle de temps régulier $t_{insp}$, dit intervalle d'inter-inspection III, et remplacé sur constat de dégradation. Ainsi, une première flèche retour R1 de l'état de dégradation intermédiaire DI vers l'état sain S indique le remplacement du composant sur détection de dégradation en inspection. Une seconde flèche retour R2 de l'état de dégradation avancée EO vers l'état sain S indique le remplacement du composant suite à un événement opérationnel.

L'objectif du modèle de défaillance est de calibrer par itération l'intervalle d'inter-inspection III de sorte que le taux de risque de dégradation avancée soit inférieur à un seuil de sécurité prédéterminé.

En effet, la Figure 4B illustre le processus de construction d'un modèle de défaillance pour un composant.

A partir du modèle de durée de vie MDDV associé au composant (bloc B21) et un intervalle d'inter-inspection initial III(0) ou courant (bloc B22), les moyens de traitement 7 calculent au bloc B23 le taux de risque de dégradation avancée $\lambda$. On notera que ce taux de risque $\lambda$ est un taux d'occurrence d'événement opérationnels EO (c'est-à-dire, le nombre d'événements opérationnels cumulés divisé par le nombre de vols).

Au bloc B24, les moyens de traitement 7 comparent le taux de risque de dégradation avancée $\lambda$ à un seuil $\sigma$ de sécurité prédéterminé. Pour plus de sécurité,

le seuil $\sigma$ correspond à un certain pourcentage $\alpha\%$ d'un seuil réglementaire de sécurité. Si le taux de risque $\lambda$ n'est pas inférieur au seuil $\sigma$, alors les moyens de traitement 7 réitèrent sur la valeur de l'intervalle d'inter-inspection III en bouclant sur le bloc B22. En revanche, si le niveau de risque $\lambda$ est inférieur au seuil $\sigma$, alors au bloc B25 les moyens de traitement 7 stockent la dernière valeur de l'intervalle d'inter-inspection III dans les moyens de stockage 9. Le but ici est de chercher la plus grande valeur de l'intervalle d'inter-inspection III qui respecte le critère de sécurité du bloc B24.

Toutefois, l'intervalle d'inter-inspection III déterminé selon le processus de la Figure 4B est propre à chaque composant et ne tient pas compte des inspections opportunistes.

Par conséquent, afin de tenir compte des inspections opportunistes, les moyens de traitement 7 utilisent au bloc B3 (voir la Figure 2) une stratégie de maintenance impliquant des actions de maintenance opportunistes sur l'ensemble des composants.

La Figure 5 illustre la structure d'un processus d'inspections opportunistes pour quelques composants.

Cet exemple illustre une stratégie de maintenance impliquant cinq composants C1 à C5.

Au bloc B31 une première inspection est programmée au niveau du composant C1. Cette inspection peut conduire à une première maintenance très légère (bloc B32), une deuxième maintenance légère (bloc B33), ou une troisième maintenance lourde (bloc B34).

La première maintenance très légère (bloc B32) n'a aucune conséquence sur les autres composants du moteur en termes d'inspections ou maintenance.

La deuxième maintenance légère (bloc B33) nécessite le remplacement du composant C1 et implique une inspection opportuniste du composant C4 (bloc B35) ainsi que des inspections opportunistes des composants C2 et C3 (bloc B36).

Au cas où on observe que le composant C4 est dégradé, on change de stratégie et on lance une maintenance lourde (bloc B34) qui peut impliquer l'envoi du moteur en atelier pour inspecter par exemple tous les composants.

Par ailleurs, si on observe qu'au moins un des deux composants C2 et C3 est dégradé, une maintenance moyenne (bloc B37) sera lancée qui conduit à l'inspection du composant C4 (bloc B35).

En outre, au bloc B38 une deuxième inspection est programmée au niveau des composants C2 et C3. En cas de dégradation d'un des deux composants, cette deuxième inspection conduit systématiquement à une maintenance moyenne (bloc B37) impliquant l'inspection du composant C4 (bloc B35). Eventuellement, on fait le même trajet que précédemment qui conduit à une maintenance lourde (bloc B34).

Enfin, au bloc B39 une troisième inspection est programmée au niveau des composants C4 et C5. En cas de dégradation d'un des deux composants, cette troisième inspection conduit systématiquement à une maintenance lourde (bloc B34).

L'exemple de la Figure 5 montre que les inspections programmées provoquent un certain nombre d'inspections opportunistes sur d'autres composants en fonction de la nature des composants et de leurs états (sains ou dégradés), et qui à leur tour conduisent à un renforcement de la maintenance du moteur. En conséquence, le programme de maintenance initialement issu des analyses de risque aux niveaux des composants individuels peut être largement minoré au vu de la stratégie de maintenance globale sur tout le moteur tout en respectant les critères de sécurité.

Ainsi, au bloc B4 (voir la Figure 2), les moyens de traitement 7 simulent de manière itérative des actions de maintenance sur l'ensemble de composants en utilisant l'ensemble de modèles de défaillances (blocs B2) et la stratégie de maintenance (bloc B3) pour relaxer les intervalles d'inter-inspections III initiaux de sorte à ce que la maintenance réellement appliquée au niveau des composants coïncide avec la maintenance initialement définie lors des analyses de risque par composant.

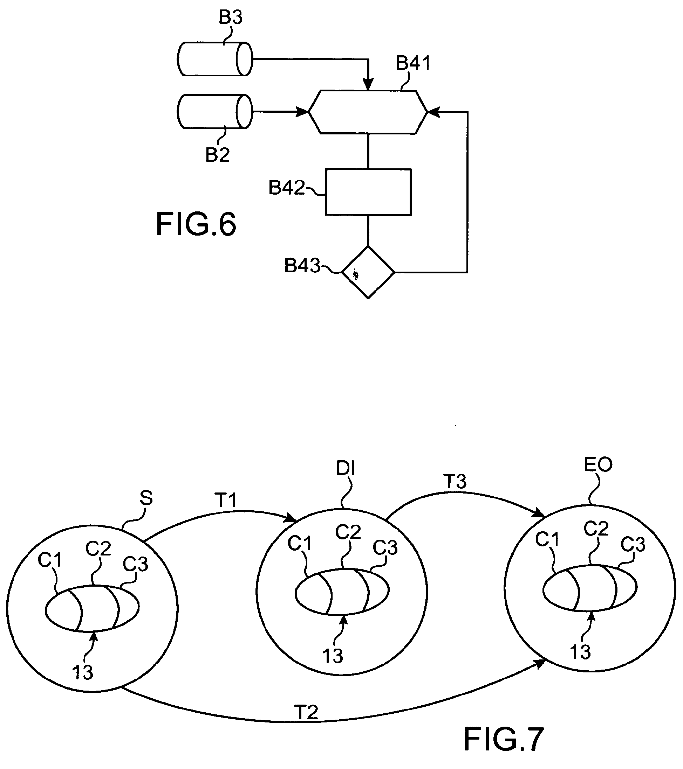

La Figure 6 illustre les grandes étapes de simulation des actions de maintenance sur l'ensemble de composants.

Plus particulièrement, au bloc B41 les moyens de traitement 7 modifient au moins un intervalle d'inter-inspection III correspondant à au moins un composant en tenant compte des actions de maintenance opportunistes (bloc B3) pour construire un modèle courant de maintenance (bloc B42).

Au bloc B43, les moyens de traitement 7 comparent le taux de risque associé à chaque composant selon le modèle courant de maintenance B42 avec le seuil de sécurité prédéterminé du composant selon les modèles de défaillances issus du bloc B2.

Tant que le critère de sécurité du bloc B43 est respecté, les moyens de traitement 7 continuent la simulation en bouclant sur le bloc B41 jusqu'à ce que le modèle courant de maintenance converge vers un dernier modèle courant de maintenance qui maximise les intervalles d'inter-inspection III des composants tout en respectant le seuil de sécurité prédéterminé de chaque composant. Le dernier modèle courant de maintenance qui correspond au modèle global d'opérations de maintenance relaxée est stocké dans les moyens de stockage 9. Il constitue une solution optimale en termes de minimisation des coûts de maintenance tout en respectant les exigences de sécurité des vols.

La Figure 7 est un exemple d'un système comportant seulement trois composants permettant d'expliciter avec plus de détails le procédé de prévision d'opérations de maintenance.

Le système 13 représente un moteur ou une partie d'un moteur constitué de trois composants C1, C2, et C3. Ces trois composants qui à l'origine sont dans un état sain S peuvent éventuellement visiter durant leur vie opérationnelle, deux états de dégradation successifs (dégradation intermédiaire DI et dégradation avancée EO) selon le graphe de type Markov.

La fonction de répartition des temps de passage de l'état sain S vers un état de dégradation de niveau supérieur est celle d'une loi de Weibull :

$$F_{\beta.\eta} = 1 - e^{-\left(\frac{t}{\eta}\right)^{\beta}}$$

Chacun des trois composants C1, C2, et C3 dispose d'une fonction de répartition de l'état sain S vers l'état de dégradation intermédiaire DI et de l'état sain S vers l'état de dégradation avancée EO.

A titre d'exemple, le tableau ci-dessous donne les paramètres de la loi de Weibull pour les trois composants C1, C2, et C3 :

|  | **C1** | **C2** | **C3** |
|---|---|---|---|
| **beta** | *3* | *2* | *1,5* |
| **eta_DI** | *1000* | *3000* | *5000* |
| **eta_EO** | *5000* | *30000* | *75000* |

Le paramètre $\beta$ est un paramètre de forme qui est assez robuste car il peut être estimé à partir d'un grand nombre de données de dégradations intermédiaires DI. Ainsi, par un raisonnement bayésien on peut prendre la même valeur de $\beta$ pour les dégradations intermédiaire DI et avancée EO. On notera que $\beta > 1$ pour les trois composants C1, C2, et C3, ce qui traduit le fait que plus le composant est vieux, plus grand est le risque qu'il tombe en panne.

Par ailleurs, le paramètre $\eta$ est un paramètre d'échelle qui dépend de l'âge moyen de dégradation et par conséquent, on ne peut pas garder la même valeur de $\eta$ pour à la fois une dégradation intermédiaire DI et une dégradation avancée EO.

Les Figures 8A-8C représentent les graphiques des lois de Weibull pour les trois composants.

La probabilité cumulée est représentée en ordonnée et le nombre de vols du moteur est représenté en abscisse. Chaque graphique représente une première loi de Weibull W1 relative à la durée de vie d'une dégradation intermédiaire DVDI et une deuxième loi de Weibull W2 relative à la durée de vie d'une dégradation avancée DVEO.

En outre, un échantillon de couples de durée de vie à dégradation intermédiaire DVDI et à dégradation avancée DVEO peut être simulé selon par exemple l'organigramme de la Figure 3C. Ainsi, à chaque composant est associé un modèle de durée vie définissant les transitions de l'état sain S vers l'état de dégradation intermédiaire DI, de l'état sain S vers l'état de dégradation avancée EO, et de l'état de dégradation intermédiaire DI vers l'état de dégradation avancée EO.

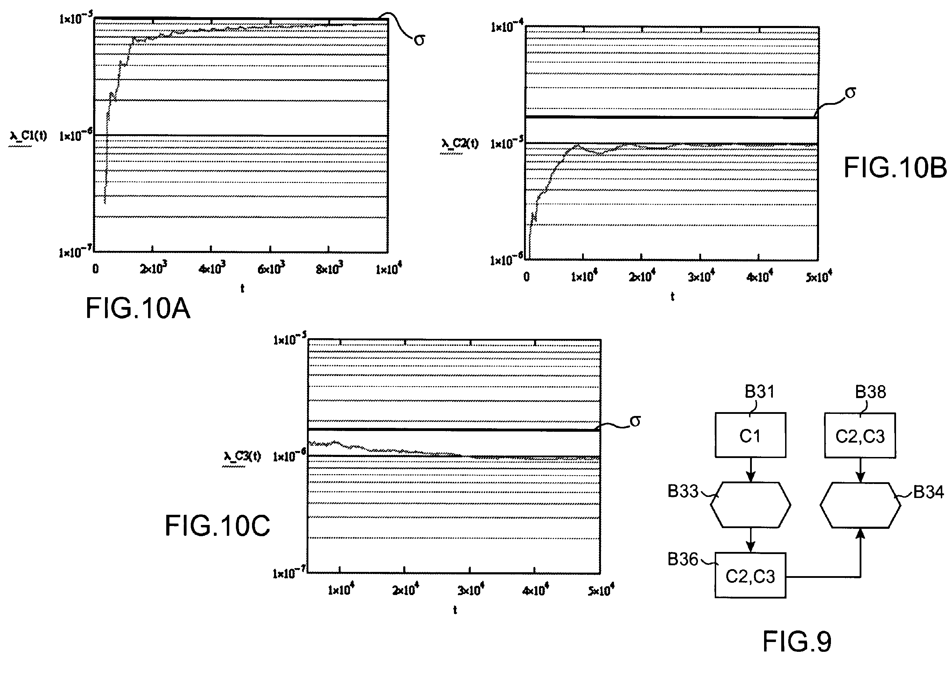

Par ailleurs, la Figure 9 illustre la structure d'un processus d'inspections opportunistes pour les trois composants. On notera que la structure de l'exemple de la Figure 9 est tirée en partie de celle de la Figure 5.

Au bloc B31 une première inspection est programmée au niveau du composant C1. Cette inspection conduit à une maintenance légère (bloc B33) nécessitant le remplacement du composant C1 et implique une inspection opportuniste des composants C2 et C3 (bloc B36).

Au cas où on observe qu'au moins un des deux composants C2 et C3 est dégradée, une maintenance moyenne (bloc B34) sera lancée qui conduit à l'inspection de tous les composants.

Finalement, au bloc B38 une deuxième inspection est programmée au niveau des composants C2 et C3. En cas de dégradation de l'un des deux composants, cette deuxième inspection conduit systématiquement à une maintenance lourde (bloc B34).

Les Figures 10A-10C représentent les graphiques des modèles de défaillances pour les trois composants.

Les graphiques sont obtenus par simulation de Monte Carlo à partir des modèles de durée de vie des composants C1, C2, et C3. Le taux de risque de dégradation avancée $\lambda$ est représenté en ordonnée et le nombre de vols du moteur est représenté en abscisse. Le taux de risque de dégradation avancée $\lambda$ pour chaque composant est inférieur au seuil $\sigma$ de sécurité.

Ces graphiques permettent de définir les intervalles d'inter-inspection III individuels ainsi que la tendance des taux de risque de dégradation avancée $\lambda$ pour les trois composants C1, C2, et C3, comme indiqué sur le tableau ci-dessous :

|  | **C1** | **C2** | **C3** |
|---|---|---|---|
| **III** | *450* | *900* | *750* |
| **Lambda** | *1,00E-05* | *1,00E-05* | *1,00E-06* |

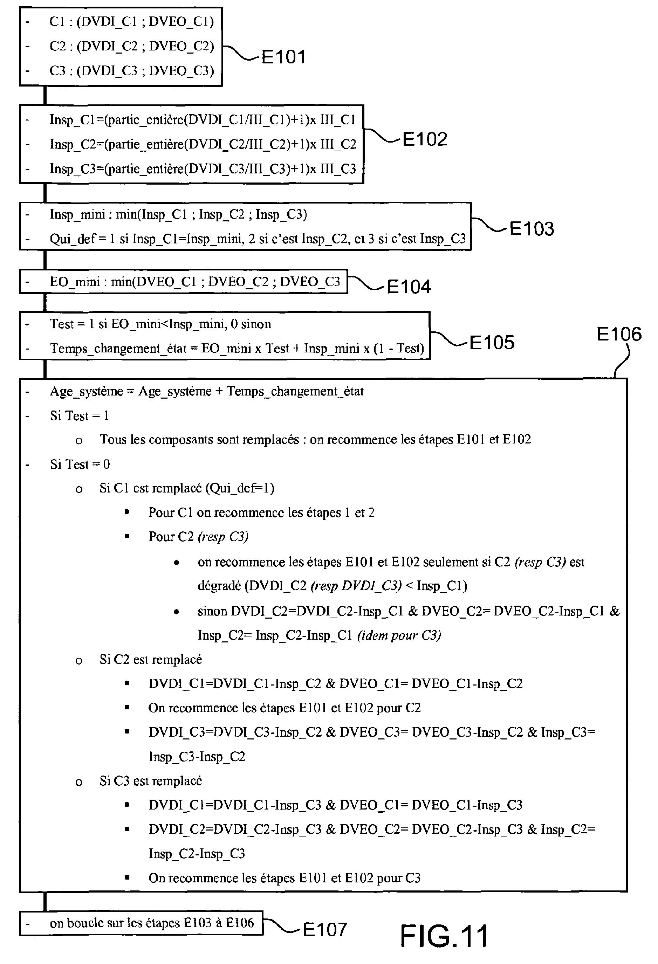

La Figure 11 illustre un algorithme de simulation des actions de maintenance sur les trois composants.

Cet algorithme simule les états visités par l'ensemble de trois composants en tenant compte des inspections opportunistes du plan de maintenance de la Figure 9.

L'étape E101 concerne la simulation des durées de vie de dégradation des trois composants. Pour chaque composant, un couple de durée de vie à dégradation intermédiaire DVDI et à dégradation avancée DVEO sont simulées :

- C1 : (DVDI_C1 ; DVEO_C1)
- C2 : (DVDI_C2 ; DVEO_C2)
- C3 : (DVDI_C3 ; DVEO_C3)

A l'étape E102, les moyens de traitement 7 déterminent le temps restant jusqu'à l'inspection détectant la dégradation. A partir des intervalles d'inter-inspection III et des durées de vie à dégradation intermédiaire DVDI déjà simulées on définit le vecteur de temps suivant :

- Insp_C1=(partie_entière(DVDI_C1/III_C1)+1)x III-C1
- Insp_C2=(partie_entière(DVDI_C2/III_C2)+1)x III_C2
- Insp-C3=(partie-entière(DVDI_C3/III_C3)+1)x III_C3

Ainsi, Insp_C1 définit la première inspection de C1 juste après la dégradation. De même pour Insp_C2 et Insp_C3.

A l'étape E103, les moyens de traitement 7 déterminent le prochain instant de restauration du système qui correspond tout simplement à l'âge minimal des premières inspections simulées à l'étape précédente :

- Insp_mini : min(Insp_C1 ; Insp_C2 ; Insp_C3)
- Qui_def = 1 si Insp_C1=Insp_mini, 2 si c'est Insp_C2, et 3 si c'est Insp_C3

Le paramètre Qui_def indique quel est le composant à remplacer au prochain instant de restauration.

A l'étape E104, les moyens de traitement 7 déterminent le prochain instant de dégradation avancée EO qui est tout simplement le minimum des durées de vie à dégradation avancée des trois composants :

- EO_mini : min(DVEO_C1 ; DVEO_C2 ; DVEO_C3)

A l'étape E105, les moyens de traitement 7 déterminent le prochain instant de changement d'état du système :

- Test = 1 si EO_mini<Insp_mini, 0 sinon
- Temps_changement_état = EO_mini x Test + Insp_mini x (1- Test)

La formule de la deuxième ligne indique si le prochain changement d'état est une dégradation avancée EO ou une restauration Insp.

Ainsi, à l'étape E105, on connaît quand est-ce que le système change d'état et on connaît aussi si la restauration est due à une dégradation avancée EO ou à une dégradation intermédiaire DI.

Ainsi, à l'étape E106, on peut réaliser une mise à jour de l'état du système en tenant compte de la stratégie de maintenance de la Figure 9.

Au départ, les moyens de traitement 7 mettent à jour l'âge du système qui est égal à l'âge qu'il avait avant, augmenté du temps de changement d'état.

Si on a eu une dégradation avancée (Test=1), la stratégie de maintenance exige le remplacement de tous les composants, et de revenir aux étapes E101 et E102.

En revanche, si on a eu une restauration (Test=0), on cherche à savoir quel composant a été remplacé. Selon un premier cas, si c'est le composant C1 qui a été remplacé, alors les moyens de traitement 7 recommencent les étapes E101 et E102 pour simuler à nouveau les durées de vie à dégradation intermédiaire DVDI et à dégradation avancée DVEO ainsi que les temps des prochaines inspections. Selon un deuxième cas (respectivement, un troisième cas), si c'est le composant C2 (resp. C3) qui a été remplacé, alors les moyens de traitement 7 recommencent les étapes E101 et E102 seulement si C2 (resp. C3) est dégradé, ce qui revient à vérifier si la durée de vie à dégradation intermédiaire de C2 (resp. de C3) est inférieure au temps d'inspection de C1. Sinon, c'est-à-dire, que C2 (resp. C3) a été inspecté et qu'il n'est pas dégradé, alors, la mise à jour consiste simplement à déterminer le temps restant jusqu'à la prochaine inspection pour C2 (resp. C3) qui est égal au temps restant qui a été déjà stocké moins le temps de la dernière inspection.

Ainsi, à l'étape E106, la mise à jour de l'état du système comporte les sous étapes suivantes :

- Age_système = Age_système + Temps_changement_état
- Si Test = 1

   o Tous les composants sont remplacés : on recommence les étapes E101 et E102

- Si Test = 0

   o Si C1 est remplacé (Qui_def=1)

      ▪ Pour C1 on recommence les étapes 1 et 2
      ▪ Pour C2 *(resp C3)*

      • on recommence les étapes E101 et E102 seulement si C2 *(resp C3)* est dégradé (DVDI_C2 *(resp DVDI_C3)* < Insp_C1)
      • sinon DVDI_C2=DVDI_C2-Insp_C1 & DVEO_C2= DVEO_C2-Insp_C1 & Insp_C2= Insp_C2-Insp_C1 *(idem pour C3)*

   o Si C2 est remplacé

      ▪ DVDI_C1=DVDI_C1-Insp_C2 & DVEO_C1= DVEO_C1-Insp_C2
      ▪ On recommence les étapes E101 et E102 pour C2
      ▪ DVDI_C3=DVDI_C3-Insp_C2 & DVEO_C3= DVEO_C3-Insp_C2 & Insp_C3= Insp_C3-Insp_C2

   o Si C3 est remplacé

      ▪ DVDI_C1=DVDI_C1-Insp_C3 & DVEO_C1= DVEO_C1-Insp_C3
      ▪ DVDI_C2=DVDI_C2Insp_C3 & DVEO_C2= DVEO_C2-Insp_C3 & Insp_C2= Insp_C2-Insp_C3
      ▪ On recommence les étapes E101 et E102 pour C3

A l'étape E107, on boucle sur les étapes E103 à E106 tant que l'âge du système est inférieur à un limite prédéfinie qui correspond en général à la durée de vie du système (de l'ordre de quelques dizaines de milliers de cycles pour un moteur d'aéronef).

Ainsi, l'algorithme permet d'illustrer l'évolution des taux de risque de dégradation avancée selon la stratégie de maintenance.

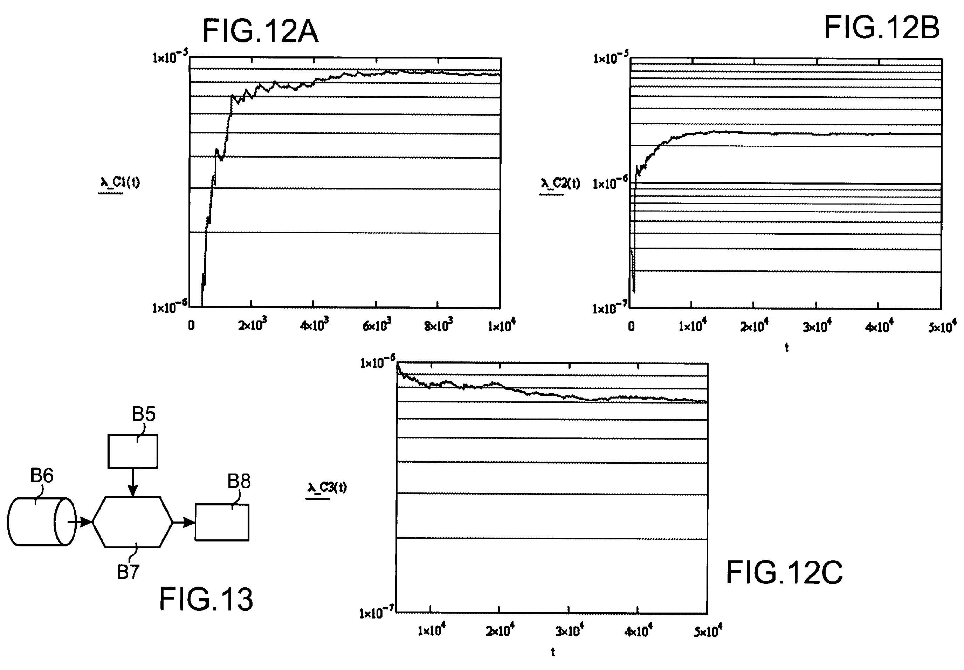

En effet, les Figures 12A-12C représentent les graphiques des modèles de défaillances pour les trois composants en tenant compte des inspections opportunistes.

Ces graphiques montrent que le taux de risque de dégradation avancée du composant C1 est faiblement diminué. En revanche, pour C2 et C3, les taux de risque de dégradation avancée sont sensiblement plus bas par rapport aux graphiques des Figures 10A-10C.

Ceci permet d'élargir les intervalles d'inter-inspection III pour retrouver un faisceau de courbes de taux de risque de dégradation avancée proche de celui des Figures 10A-10C.

A partir de la stratégie de maintenance de la Figure 5, on peut pronostiquer l'influence des intervalles d'inter-inspection III sur les taux de risque de dégradation avancée.

L'intervalle d'inter-inspection III de C1 ne peut être changé car il est le seul à avoir une influence sur le taux de risque de dégradation avancée de C1. En revanche, les intervalles d'inter-inspection III de C2 et C3 peuvent être modifiés de façon complètement indépendante.

Finalement, de proche en proche, la simulation réalisée selon l'algorithme de la Figure 11, converge vers un modèle global d'opérations de maintenance relaxée défini par les paramètres indiqués sur le tableau ci-dessous :

|  | C1 | C2 | C3 |
|---|---|---|---|
| **III** | *450* | *NA* | *900* |
| **Lambda** | *1,00E-05* | *2,00E-06* | *1,00E-06* |

Ce tableau montre que le composant C2 n'est plus inspecté périodiquement et que l'intervalle d'inter-inspection III de C3 est augmenté à 900 (contre 700 au départ). Ceci permet de programmer des inspections plus espacés dans le temps tout en respectant les critères de sécurité.

Par ailleurs, la Figure 13 est un schéma en bloc illustrant la détermination des prévisions calendaires selon l'invention.

Le bloc B6 est un modèle de comportement du moteur comprenant des données de comportement parmi l'ensemble de données suivantes : temps d'exploitation moyen du moteur, durée moyenne des missions, nombre de missions par jour, âge du moteur, et maintenances déjà réalisées sur le moteur.

Au bloc B7, les moyens de traitement 7 tiennent compte du modèle de comportement B6 du moteur et du modèle global B5 pour déterminer un modèle de prévisions calendaires B8 comportant des actions de maintenance à appliquer sur le moteur. On notera que pour une flotte de moteurs d'aéronef, les différents modèles de comportement des moteurs sont concaténés pour former un modèle de comportement de la flotte.

Ainsi, le modèle de prévisions calendaires pour une flotte de moteurs met en place des maintenances préventives efficaces, moins coûteuses, et garantissant une disponibilité importante sans faire de compromis sur la sécurité.

**Revendications**

1. Procédé de prévision d'opérations de maintenance à appliquer sur un moteur (13) ou une partie du moteur comportant un ensemble de composants (C1-C5), comprenant les étapes suivantes :

   - construire un modèle de durée de vie (B1) pour chaque composant dudit ensemble de composants,
   - analyser le modèle de durée de vie associé à chaque composant pour construire un ensemble de modèles de défaillances (B2) correspondant audit ensemble de composants, chaque composant étant associé à un modèle de défaillance définissant un intervalle d'inter-inspection traduisant un taux de risque de dégradation avancée inférieur à un seuil de sécurité prédéterminé,

   **caractérisé en ce qu'**il comprend ensuite les étapes suivantes :

   - définir une stratégie de maintenance comprenant des inspections opportunistes sur ledit ensemble de composants,
   - simuler de manière itérative des actions de maintenance sur ledit ensemble de composants en utilisant ledit ensemble de modèles de défaillances et ladite stratégie de maintenance pour construire un modèle global d'opérations de maintenance relaxée qui prend en compte les inspections opportunistes tout en respectant le seuil de sécurité prédéterminé de chaque composant.

2. Procédé selon la revendication 1, **caractérisé en ce que** chaque itération de ladite simulation comporte les étapes suivantes :

   - modifier au moins un intervalle d'inter-inspection correspondant à au moins un composant en tenant compte des inspections opportunistes pour construire un modèle courant de maintenance,
   - comparer le taux de risque associé à chaque composant selon ledit modèle courant de maintenance avec le seuil de sécurité prédéterminé dudit composant selon les modèles de défaillances, et
   - continuer la simulation jusqu'à ce que le modèle courant de maintenance converge vers un dernier modèle courant de maintenance qui maximise les intervalles d'inter-inspection des composants tout en respectant le seuil de sécurité prédéterminé de chaque composant, ledit dernier modèle courant de maintenance étant ledit modèle global d'opérations de maintenance relaxée.

3. Procédé selon la revendication 1 ou 2, **caractérisé en ce qu'**il comporte en outre une définition d'un modèle de comportement du moteur comprenant des données de comportement parmi l'ensemble de données suivantes : temps d'exploitation moyen du moteur, durée moyenne des missions, nombre de missions par jour, âge du moteur, et maintenances déjà réalisées sur le moteur.

4. Procédé selon la revendication 3, **caractérisé en ce qu'**il comporte une détermination de prévisions calendaires des actions de maintenance à appliquer sur ledit moteur en tenant compte dudit modèle de comportement du moteur.

5. Procédé selon l'une quelconque des revendications 1 à 4, **caractérisé en ce que** la construction d'un modèle de durée de vie pour un composant donné comporte les étapes suivantes :

   - déterminer une première loi d'un premier temps de passage $t_{D/S}$ d'un état sain vers un état de dégradation intermédiaire dudit composant,
   - déterminer une deuxième loi d'un deuxième temps de passage $t_{EO/S}$ d'un état sain vers un état de dégradation avancée dudit composant, et
   - utiliser lesdites première et deuxième lois pour estimer une troisième loi d'un troisième temps de passage $t_{EO/D}$ de l'état de dégradation intermédiaire vers l'état de dégradation avancée dudit composant, ladite troisième loi étant estimée selon une loi d'association de dépendance forte entre lesdites première et deuxième lois si ces dernières sont dépendantes, et ladite troisième loi étant estimée selon une loi d'association de dépendance à minima d'information si lesdites première et deuxième lois sont indépendantes, sous contrainte que le premier temps de passage soit plus petit que le deuxième temps de passage.

6. Procédé selon la revendication 5, **caractérisé en ce qu'**il comporte les étapes suivantes :

   - simuler un échantillon de nombres $\alpha_i$ uniformément répartis sur un intervalle [0; 1],
   - calculer des premier quantiles $q_{D/S}(\alpha_i)$ et des deuxième quantiles $q_{EO/S}(\alpha_i)$ de niveau $\alpha_i$ desdites première et deuxième lois respectivement, et
   - estimer ladite troisième loi en fonction desdits premier et deuxième quantiles.

7. Procédé selon la revendication 6, **caractérisé en ce que** si lesdites première et deuxième lois sont dépendantes, la troisième loi est estimée selon des quantiles $q_{EO/D}(\alpha_i)$ égaux à la différence entre les premiers $q_{D/S}(\alpha_i)$ et deuxièmes $q_{EO/S}(\alpha_i)$ quantiles desdites première et seconde lois.

8. Procédé selon la revendication 6, **caractérisé en ce que** si lesdites première et deuxième lois sont indépendantes, l'estimation de la troisième loi comporte les étapes suivantes :

   - associer des durées de passage des premiers $q_{D/S}(\alpha_i)$ et deuxièmes $q_{EO/S}(\alpha_i)$ quantiles, en garantissant une indépendance entre elles sous contrainte que le premier temps de passage $t_{D/S}$ soit plus petit que le deuxième temps de passage $t_{EO/S}$, et
   - estimer la troisième loi selon un échantillon de durée déterminé par soustraction desdites durées de passage des premiers $q_{D/S}(\alpha_i)$ et deuxièmes $q_{EO/S}(\alpha_k)$ quantiles associées entre elles.

9. Procédé selon l'une quelconque des revendications 1 à 8, **caractérisé en ce qu'**il est utilisé pour une flotte de moteurs d'aéronef.

10. Système de prévision d'opérations de maintenance à appliquer sur un moteur (13) ou une partie du moteur comportant un ensemble de composants, comportant :

    - des moyens de traitement (7) pour construire un modèle de durée de vie (B1) pour chaque composant dudit ensemble de composants,
    - des moyens de traitement (7) pour analyser le modèle de durée de vie associé à chaque composant afin de construire un ensemble de modèles de défaillances (B2) correspondant audit ensemble de composants, chaque composant étant associé à un modèle de défaillance définissant un intervalle d'inter-inspection traduisant un taux de risque de dégradation avancée inférieur à un seuil de sécurité prédéterminé, **caractérisé en ce qu'**il comporte en outre :

      - des moyens de traitement (7) pour définir une stratégie de maintenance (B3) comprenant des inspections opportunistes sur ledit ensemble de composants, et
      - des moyens de traitement (7) pour simuler de manière itérative des actions de maintenance sur ledit ensemble de composants en utilisant ledit ensemble de modèles de défaillances (B2) et ladite stratégie de maintenance (B3) afin de construire un modèle global d'opérations de maintenance relaxée qui prend en compte les inspections opportunistes tout en respectant le seuil de sécurité prédéterminé de chaque composant.

**Patentansprüche**

1. Verfahren zur Vorhersage von Wartungsoperationen, die bei einem Motor (13) oder einem Teil des Motors auszuführen sind, umfassend eine Gesamtheit von Komponenten (C1-C5), umfassend die folgenden Schritte:

   - Konstruieren eines Lebensdauermodells (B1) für jede Komponente der Gesamtheit von Komponenten,
   - Analysieren des Lebensdauermodells, das jeder Komponente zugeordnet ist, zum Konstruieren einer Gesamtheit von Fehlermodellen (B2) entsprechend der Gesamtheit von Komponenten, wobei jede Komponente einem Fehlermodell zugeordnet ist, das ein Zwischeninspektionsintervall definiert, welches einen Grad des Risikos der fortgeschrittenen Verschlechterung unterhalb einer vorbestimmten Sicherheitsschwelle ausdrückt,

   **dadurch gekennzeichnet, dass** es anschließend die folgende Schritte umfasst:

   - Definieren einer Wartungsstrategie, umfassend opportunistische Inspektionen bei der Gesamtheit von Komponenten,
   - iteratives Simulieren der Wartungsaktionen bei der Gesamtheit von Komponenten unter Verwendung der Gesamtheit von Fehlermodellen und der Wartungsstrategie zum Konstruieren eines globalen Modells von relaxierten Wartungsoperationen, das die opportunistischen Inspektionen berücksichtigt und die vorbestimmte Sicherheitsschwelle jeder Komponente respektiert.

2. Verfahren nach Anspruch 1, **dadurch gekennzeichnet, dass** jede Iteration der Simulation die folgenden Schritte umfasst:

- Modifizieren wenigstens eines Zwischeninspektionsintervalls entsprechend wenigstens einer Komponente unter Berücksichtigung der opportunistischen Inspektionen, um ein momentanes Wartungsmodell zu konstruieren,
- Vergleichen des Grads des Risikos, das jeder Komponente gemäß dem momentanen Wartungsmodell zugeordnet ist, mit der vorbestimmten Sicherheitsschwelle der Komponente gemäß den Fehlermodellen, und
- Fortsetzen der Simulation, bis das momentane Wartungsmodell zu einem letzten momentanen Wartungsmodell konvergiert, das die Zwischeninspektionsintervalle der Komponenten maximiert und hierbei die vorbestimmte Sicherheitsschwelle jeder Komponente respektiert, wobei das letzte momentane Wartungsmodell das globale Modell von relaxierten Wartungsoperationen ist.

3. Verfahren nach Anspruch 1 oder 2, **dadurch gekennzeichnet, dass** es ferner eine Definition eines Verhaltensmodells des Motors umfasst, umfassend Verhaltensdaten aus der Gesamtheit von folgenden Daten: mittlere Betriebszeit des Motors, mittlere Dauer der Einsätze, Zahl von Einsätzen pro Tag, Alter des Motors sowie bereits bei dem Motor ausgeführte Wartungen.

4. Verfahren nach Anspruch 3, **dadurch gekennzeichnet, dass** es eine Bestimmung von kalendarischen Vorhersagen der Wartungsaktionen umfasst, die bei dem Motor auszuführen sind, unter Berücksichtigung des Verhaltensmodells des Motors.

5. Verfahren nach einem der Ansprüche 1 bis 4, **dadurch gekennzeichnet, dass** die Konstruktion eines Lebensdauermodells für eine gegebene Komponente die folgenden Schritte umfasst:

- Bestimmen eines ersten Gesetzes einer ersten Übergangszeit $t_{D/S}$ von einem intakten Zustand zu einem Zwischenverschlechterungszustand der Komponente,
- Bestimmen eines zweiten Gesetzes einer zweiten Übergangszeit $t_{EO/S}$ eines intakten Zustands zu einem fortgeschrittenen Verschlechterungszustand der Komponente, und
- Verwenden des ersten und des zweiten Gesetzes zum Abschätzen eines dritten Gesetzes einer dritten Übergangszeit $t_{EO/D}$ des Zwischenverschlechterungszustands in den fortgeschrittenen Verschlechterungszustand der Komponente, wobei das dritte Gesetz abgeschätzt wird gemäß einem Zuordnungsgesetz starker Abhängigkeit zwischen dem ersten und dem zweiten Gesetz, wenn diese letztgenannten abhängig sind, und wobei das dritte Gesetz abgeschätzt wird gemäß einem Zuordnungsgesetz mit Informationsminimaabhängigkeit, wenn das erste und das zweite Gesetz unabhängig sind, unter der Bedingung, dass die erste Übergangszeit kürzer als die zweite Übergangszeit ist.

6. Verfahren nach Anspruch 5, **dadurch gekennzeichnet, dass** es die folgenden Schritte umfasst:

- Simulieren einer Probe von Zahlen $\alpha_i$, die gleichmäßig über ein Intervall [0;1] verteilt sind,
- Berechnen von ersten Quantilen $q_{D/S}(\alpha_i)$ und von zweiten Quantilen $q_{EO/S}(\alpha_i)$ des Niveaus $\alpha_i$ des ersten beziehungsweise des zweiten Gesetzes, und
- Abschätzen des dritten Gesetzes als Funktion des ersten und des zweiten Quantils.

7. Verfahren nach Anspruch 6, **dadurch gekennzeichnet, dass** dann, wenn das erste und das zweite Gesetz abhängig sind, das dritte Gesetz abgeschätzt wird gemäß Quantilen $q_{EO/D}(\alpha_i)$ gleich der Differenz zwischen den ersten Quantilen $q_{D/S}(\alpha_i)$ und den zweiten Quantilen $q_{EO/S}(\alpha_i)$ des ersten beziehungsweise zweiten Gesetzes.

8. Verfahren nach Anspruch 6, **dadurch gekennzeichnet, dass** dann, wenn das erste und das zweite Gesetz unabhängig sind, die Abschätzung des dritten Gesetzes die folgenden Schritte umfasst:

- Zuordnen der Übergangsdauern der ersten Quantile $q_{D/S}(\alpha_i)$ und der zweiten Quantile $q_{EO/S}(\alpha_k)$ unter Sicherstellung einer Unabhängigkeit zwischen ihnen unter der Bedingung, dass die erste Übergangszeit $t_{D/S}$ kleiner als die zweite Übergangszeit $t_{EO/S}$ ist, und
- Abschätzen des dritten Gesetzes gemäß einer Probe mit bestimmter Dauer durch Subtrahieren der Übergangsdauern des ersten Quantils $q_{D/S}(\alpha_i)$ und des zweiten Quantils $q_{EO/S}(\alpha_k)$ voneinander.

9. Verfahren nach einem der Ansprüche 1 bis 8, **dadurch gekennzeichnet, dass** es für eine Flotte von Luftfahrzeugmotoren verwendet wird.

**10.** System zur Vorhersage von Wartungsoperationen, die bei einem Motor (13) oder einen Teil des Motors auszuführen sind, umfassend eine Gesamtheit von Komponenten, umfassend:

- Verarbeitungsmittel (7) zum Konstruieren eines Lebensdauermodells (B1) für jede Komponente der Gesamtheit von Komponenten,
- Verarbeitungsmittel (7) zum Analysieren des Lebensdauermodells, das jeder Komponente zugeordnet ist, zum Konstruieren einer Gesamtheit von Fehlermodellen (B2) entsprechend der Gesamtheit von Komponenten, wobei jede Komponente einem Fehlermodell zugeordnet ist, das ein Zwischeninspektionsintervall definiert, welches einen Grad des Risikos der fortgeschrittenen Verschlechterung unterhalb einer vorbestimmten Sicherheitsschwelle ausdrückt,

**dadurch gekennzeichnet, dass** es ferner umfasst:

- Verarbeitungsmittel (7) zum Definieren einer Wartungsstrategie (B3), umfassend opportunistische Inspektionen auf der Gesamtheit von Komponenten, und
- Verarbeitungsmittel (7) zum iterativen Simulieren der Wartungsaktionen auf der Gesamtheit von Komponenten unter Verwendung der Gesamtheit von Fehlermodellen (B2) und der Wartungsstrategie (B3) zum Konstruieren eines globalen Modells von relaxierten Wartungsoperationen, das die opportunistischen Inspektionen berücksichtigt und die vorbestimmte Sicherheitsschwelle jeder Komponente respektiert.

**Claims**

**1.** A method for forecasting maintenance operations to be applied to an engine (13) or a part of the engine including a set of components (C1-C5), **characterised in that** it includes the following steps:

- building a lifetime model (B1) for each component of said set of components,
- analysing the lifetime model associated with each component to build a set of failure models (B2) corresponding to said set of components, each component being associated with a failure model defining an inter-inspection interval reflecting an advanced degradation risk rate lower than a predetermined safety threshold,
- defining a maintenance strategy comprising opportunistic inspections on said set of components,
- iteratively simulating maintenance actions on said set of components by using said set of failure models and said maintenance strategy to build a global model of relaxed maintenance operations which takes the opportunistic inspections into account while fulfilling the predetermined safety threshold of each component.

**2.** The method according to claim 1, **characterised in that** each iteration of said simulation includes the following steps:

- modifying at least one inter-inspection interval corresponding to at least one component by taking the opportunistic inspections into account to build a current maintenance model,
- comparing the risk rate associated with each component according to said current maintenance model with said predetermined safety threshold of said component according to the failure models, and
- continuing the simulation until the current maintenance model converges on a last current maintenance model which maximizes the inter-inspection intervals of the components while fulfilling the predetermined safety threshold of each component, said last current maintenance model being said global model of relaxed maintenance operations.

**3.** The method according to claim 1 or 2, **characterised in that** it further includes defining a behaviour model of the engine comprising behaviour data from the following data set: mean running time of the engine, mean duration of the missions, number of missions per day, engine age, and maintenances already performed on the engine.

**4.** The method according to claim 3, **characterised in that** it includes determining calendar forecasts of the maintenance actions to be applied to said engine by taking said behaviour model of the engine into account.

**5.** The method according to any of claims 1 to 4, **characterised in that** building a lifetime model for a given component includes the following steps:

- determining a first law of a first transit time $t_{D/S}$ from a safe condition to an intermediate degradation condition of said component,
- determining a second law of a second transit time $t_{EO/S}$ from a safe condition to an advanced degradation condition of said component, and
- using said first and second laws to assess a third law of a third transit time $t_{EO/D}$ from the intermediate degradation condition to said advanced degradation condition of said component, said third law being assessed according to a strong dependency association law between said first and second laws if they are dependent; and said third law being assessed according to a minimum information dependence association law if said first and second laws are independent, with the proviso that the first transit time is shorter than the second transit time.

6. The method according to claim 5, **characterised in that** it includes the following steps:

- simulating a sample of numbers $\alpha_i$ evenly distributed on an interval [0; 1],
- calculating first quantiles $q_{D/S}(\alpha_i)$ and second quantiles $q_{EO/S}(\alpha_i)$ of level $\alpha_i$ of said first and second laws respectively, and
- assessing said third law as a function of said first and second quantiles.

7. The method according to claims 6, **characterised in that** if said first and second laws are dependent, the third law is assessed according to quantiles $q_{EO/D}(\alpha_i)$ equal to the difference between the first $q_{D/S}(\alpha_i)$ and second $q_{EO/S}(\alpha_i)$ quantiles of said first and second laws.

8. The method according to claims 6, **characterised in that** if said first and second laws are independent, the assessment of the third law includes the following steps:

- associating transit durations of the first $q_{D/S}(\alpha_i)$ and second $q_{EO/S}(\alpha_k)$ quantiles, by ensuring an independency between them with the proviso that the first transit time $t_{D/S}$ is shorter than the second transit time $t_{EO/S}$, and
- assessing the third law according to a duration sample determined by subtracting said transit durations of the first $q_{D/S}(\alpha_i)$ and second $q_{EO/S}(\alpha_k)$ quantiles associated between them.

9. The method according to any of claims 1 to 8, **characterised in that** it is used for a fleet of aircraft engines.

10. A system for forecasting maintenance operations to be applied to an engine (13) or a part of the engine including a set of components, **characterised in that** it includes:

- processing means (7) for building a lifetime model (B1) for each component of said set of components,
- processing means (7) for analysing the lifetime model associated with each component in order to build a set of failure models (B2) corresponding to said set of components, each component being associated with a failure model defining an inter-inspection interval reflecting an advanced degradation risk rate lower than a predetermined safety threshold,
- processing means (7) for defining a maintenance strategy (B3) comprising opportunistic inspections on said set of components,
- processing means (7) for iteratively simulating maintenance actions on said set of components by using said set of failure models (B2) and said maintenance strategy (B3) in order to build a global model of relaxed maintenance operations which takes the opportunistic inspections into account while fulfilling the predetermined safety threshold of each component.

FIG.1

FIG.2

S    T1    T3    EO

DI

T2    FIG.3A

B11    B15    B16    B13

B12    FIG.3B    B14

E1

FIG.3C

E2

E3

E4

E5

E51

E52

E53

E54

FIG.3D

E55

E56

E57

E58

R2

S

T1

DI

T3

EO

R1

FIG.4A

B21

MDDV

| | | (o)

B22

B23

λ_EO

B24

λ_EO < σ

B25

| | |

## FIG.4B

B31

C1

B38

C2,C3

B39

C4,C5

B32

B33

B37

B34

## FIG.5

B35

C4

B36

C2,C3

B3

B41

B2

B42

FIG.6

B43

S    T1    DI    T3    EO

C1  C2  C3        C1  C2  C3        C1  C2  C3

13                13                13

T2

FIG.7

FIG.8A

FIG.8B

FIG.8C

EP 2 859 421 B1

FIG.10A

FIG.10B

FIG.10C

FIG.9

EP 2 859 421 B1

- C1 : (DVDI_C1 ; DVEO_C1)
- C2 : (DVDI_C2 ; DVEO_C2)     E101
- C3 : (DVDI_C3 ; DVEO_C3)

- Insp_C1=(partie_entière(DVDI_C1/III_C1)+1)x III_C1
- Insp_C2=(partie_entière(DVDI_C2/III_C2)+1)x III_C2     E102
- Insp_C3=(partie_entière(DVDI_C3/III_C3)+1)x III_C3

- Insp_mini : min(Insp_C1 ; Insp_C2 ; Insp_C3)
- Qui_def = 1 si Insp_C1=Insp_mini, 2 si c'est Insp_C2, et 3 si c'est Insp_C3     E103

- EO_mini : min(DVEO_C1 ; DVEO_C2 ; DVEO_C3)     E104

- Test = 1 si EO_mini<Insp_mini, 0 sinon
- Temps_changement_état = EO_mini x Test + Insp_mini x (1 - Test)     E105          E106

- Age_système = Age_système + Temps_changement_état
- Si Test = 1
  - o Tous les composants sont remplacés : on recommence les étapes E101 et E102
- Si Test = 0
  - o Si C1 est remplacé (Qui_def=1)
    - ▪ Pour C1 on recommence les étapes 1 et 2
    - ▪ Pour C2 *(resp C3)*
      - • on recommence les étapes E101 et E102 seulement si C2 *(resp C3)* est dégradé (DVDI_C2 *(resp DVDI_C3)* < Insp_C1)
      - • sinon DVDI_C2=DVDI_C2-Insp_C1 & DVEO_C2= DVEO_C2-Insp_C1 & Insp_C2= Insp_C2-Insp_C1 *(idem pour C3)*
  - o Si C2 est remplacé
    - ▪ DVDI_C1=DVDI_C1-Insp_C2 & DVEO_C1= DVEO_C1-Insp_C2
    - ▪ On recommence les étapes E101 et E102 pour C2
    - ▪ DVDI_C3=DVDI_C3-Insp_C2 & DVEO_C3= DVEO_C3-Insp_C2 & Insp_C3= Insp_C3-Insp_C2
  - o Si C3 est remplacé
    - ▪ DVDI_C1=DVDI_C1-Insp_C3 & DVEO_C1= DVEO_C1-Insp_C3
    - ▪ DVDI_C2=DVDI_C2-Insp_C3 & DVEO_C2= DVEO_C2-Insp_C3 & Insp_C2= Insp_C2-Insp_C3
    - ▪ On recommence les étapes E101 et E102 pour C3

- on boucle sur les étapes E103 à E106     E107          FIG.11

FIG.12A

$\lambda\_C1(t)$

FIG.12B

$\lambda\_C2(t)$

t

FIG.12C

$\lambda\_C3(t)$

t

FIG.13

B5

B6

B8

B7

EP 2 859 421 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20080234979 A

- US 20060126608 A

**Littérature non-brevet citée dans la description**

- An Intelligent Opportunistic Maintenance (OM) System : A Genetic Algorithm Approach. **MURAD S. SAMHOURI.** TIC-STH. IEEE, 2009, 60-65